(19) Europäisches Patentamt
European Patent Office
Office européen des brevets

(11) EP 3 333 225 A1

(12) EUROPEAN PATENT APPLICATION
published in accordance with Art. 153(4) EPC

(43) Date of publication:
13.06.2018 Bulletin 2018/24

(21) Application number: 16835117.9

(22) Date of filing: 05.08.2016

(51) Int Cl.:
C08L 53/00 (2006.01)
C08K 3/08 (2006.01)
C08L 21/00 (2006.01)
C08L 33/06 (2006.01)
H01B 1/00 (2006.01)
H01B 1/22 (2006.01)
H01B 5/14 (2006.01)

(86) International application number:
PCT/JP2016/073204

(87) International publication number:
WO 2017/026420 (16.02.2017 Gazette 2017/07)

(84) Designated Contracting States:
AL AT BE BG CH CY CZ DE DK EE ES FI FR GB GR HR HU IE IS IT LI LT LU LV MC MK MT NL NO PL PT RO RS SE SI SK SM TR
Designated Extension States:
BA ME
Designated Validation States:
MA MD

(30) Priority: 07.08.2015 JP 2015156576
17.11.2015 JP 2015225225
26.01.2016 PCT/JP2016/052126

(71) Applicant: Taiyo Ink Mfg. Co., Ltd.
Hiki-gun, Saitama 355-0215 (JP)

(72) Inventor: SHIOZAWA Naoyuki
Saitama 355-0215 (JP)

(74) Representative: Hoffmann Eitle
Patent- und Rechtsanwälte PartmbB
Arabellastraße 30
81925 München (DE)

# (54) ELECTROCONDUCTIVE COMPOSITION, CONDUCTOR, AND FLEXIBLE PRINTED WIRING BOARD

(57) Provided are an electroconductive composition capable of affording a conductor having excellent stretchability and excellent electrical resistance stability; a conductor obtained from the electroconductive composition; and a flexible printed wiring board including a patterned conductor formed using the electroconductive composition. It is an electroconductive composition or the like containing: at least one selected from a block copolymer and a functional group-containing elastomer; and a chain-like silver powder in the form of aggregate particles into which microparticles have aggregated, in which the chain-like silver powder has a tap density of 2.0 g/cm$^3$ or less. The block copolymer is preferably a block copolymer represented by the below-mentioned formula (I):

$$X_1\text{-}Y\text{-}X_2 \qquad (I)$$

(wherein, $X_1$ and $X_2$ independently represent a polymer unit having a glass transition point Tg of 0°C or more; and Y represents a polymer unit having a glass transition point Tg of less than 0°C).

EP 3 333 225 A1

FIG. 1

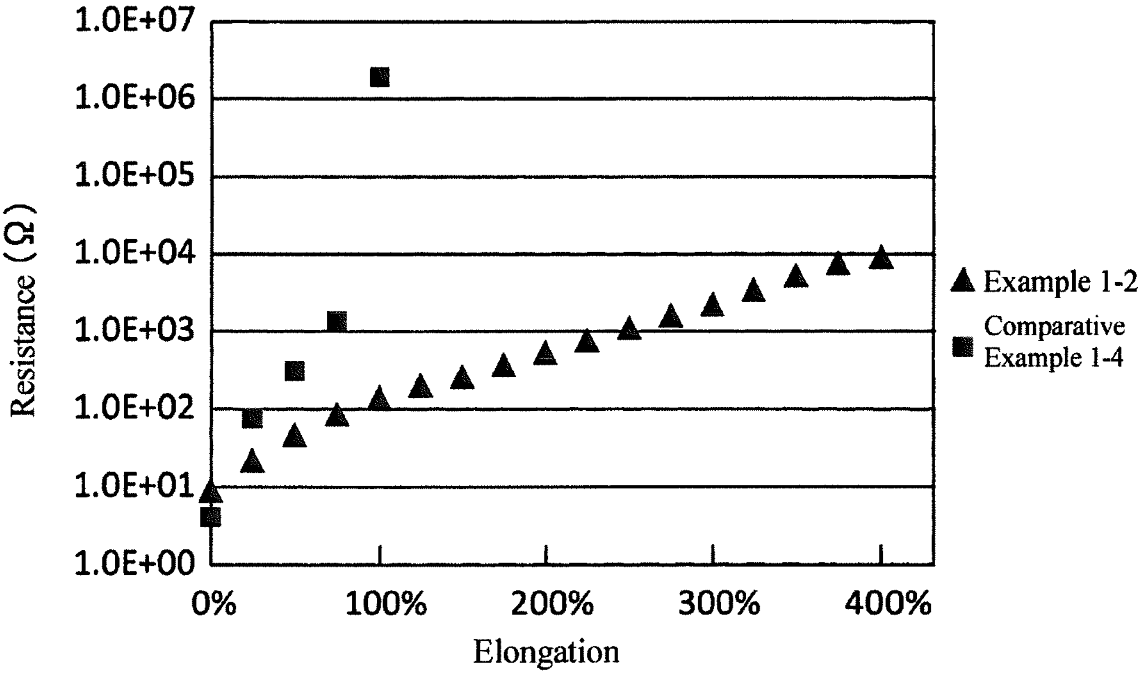
1.0E+07
1.0E+06
1.0E+05
1.0E+04
1.0E+03
1.0E+02
1.0E+01
1.0E+00
Resistance (Ω)
0%
100%
200%
300%
400%
Elongation
Example 1-2
Comparative Example 1-4

## Description

TECHNICAL FIELD

The present invention relates to an electroconductive composition, a conductor, and a flexible printed wiring board.

BACKGROUND ART

In a method of forming patterned conductors such as electrodes on printed wiring boards and the like, a paste material made of a metal powder mixed with an organic binder is used. Such a conductor generally has high hardness, but in flexible printed wiring boards, conductors having flex resistance are conventionally used (see, for example, Patent Document 1).

At the same time, conductors are being required to have stretchability imparted thereto, along with the recent growth of the wearable device field. In particular, wearable devices more closely in contact with the body require a higher degree of stretchability.

RELATED ART DOCUMENT

PATENT DOCUMENT

Patent Document 1: Japanese Unexamined Patent Application Publication No. 2001-261778

SUMMARY OF THE INVENTION

PROBLEMS TO BE SOLVED BY THE INVENTION

However, it has been found that conductors having flex resistance used for conventional flexible printed wiring boards have a problem with electrical resistance stability, in that a strong expansion and contraction, as it is applied to wearable devices, is repeatedly applied to the conductors, resulting in an increase in resistance and breaking of wiring.

Thus, an object of the present invention is to provide: an electroconductive composition capable of affording a conductor having excellent stretchability and excellent electrical resistance stability; a conductor obtained from the electroconductive composition; and a flexible printed wiring board including a patterned conductor formed using the electroconductive composition.

MEANS FOR SOLVING THE PROBLEMS

The present inventor has previously found that blending a silver powder and at least one selected from a block copolymer and a functional group-containing elastomer can afford a conductor having a remarkably improved stretchability. Furthermore, the present inventor has intensively studied in view of the above-mentioned matter and has consequently come to complete the present invention by finding out that, for the electroconductive composition, the problem can be solved by combining a specific silver powder and at least one selected from a block copolymer and a functional group-containing elastomer.

In other words, the electroconductive composition according to the present invention is characterized by containing: at least one selected from a block copolymer and a functional group-containing elastomer; and an agglomerate silver powder in the form of aggregate particles into which microparticles have aggregated, in which the chain-like silver powder has a tap density of 2.0 g/cm$^3$ or less.

In the electroconductive composition according to the present invention, the block copolymer is preferably a block copolymer represented by the below-mentioned formula (I):

$$X_1\text{-}Y\text{-}X_2 \qquad \text{(I)}$$

(wherein, $X_1$ and $X_2$ independently represent a polymer unit having a glass transition point Tg of 0°C or more; and Y represents a polymer unit having a glass transition point Tg of less than 0°C).

In the electroconductive composition according to the present invention, the block copolymer is preferably a polymethyl(meth)acrylate/poly-n-butyl (meth)acrylate/polymethyl(meth)acrylate triblock copolymer.

In the electroconductive composition according to the present invention, the block copolymer preferably has a tensile elongation at break of 300 to 600%.

In the electroconductive composition according to the present invention, the chain-like silver powder is preferably a chain-like silver powder in the form of aggregate particles into which 1 μm or less microparticles have aggregated.

In the electroconductive composition according to the present invention, the blended amount of the chain-like silver powder is preferably 70 to 90 mass% with respect to all solid content contained in the electroconductive composition.

The conductor according to the present invention is characterized by being obtained from the electroconductive composition.

The flexible printed wiring board according to the present invention is characterized by including a patterned conductor formed on an elastomer sheet using the electroconductive composition.

EFFECTS OF THE INVENTION

The present invention can provide: an electroconductive composition capable of affording a conductor having excellent stretchability and excellent electrical resistance stability; a conductor obtained from the electroconductive composition; and a flexible printed wiring board including a patterned conductor formed using the electroconductive composition.

BRIEF DESCRIPTION OF THE DRAWINGS

FIG. 1 is a plot showing the relationship between elongation and resistance of the electroconductive composition in Example 1-2 and Comparative Example 1-4 in the measurements of resistance at a 400% elongation in Examples.

MODE FOR CARRYING OUT THE INVENTION

In the present invention, the term "electroconductive composition" refers to a composition having electroconductivity by itself or a composition having electroconductivity improved by processing. In particular, the electroconductive composition refers to a composition that can form a conductor through heat treatment. Heat treatment is, for example, drying or thermosetting. Heat treatment can be preceded by molding. An example of an electroconductive composition is an electroconductive composition for forming a conductive circuit.

In the present invention, conductors and the like having excellent solvent resistance in addition to excellent stretchability and electrical resistance stability can be obtained by combining a functional group-containing elastomer and the above-mentioned specific silver powder. This can reduce the adverse effects of an increase in resistance and breaking of wiring in a conductor, for example, when a patterned conductor such as an electrode is coated with an overcoat layer that is formed on the conductor for the purpose of improving reliability and even if the conductor is exposed to the exudation of a solvent from an overcoat agent during the formation of the layer using the overcoat agent.

Below, components contained in the electroconductive composition according to the present invention will be described in detail.

[At least one selected from block copolymer and functional group-containing elastomer]

The electroconductive composition according to the present invention contains at least one selected from a block copolymer and a functional group-containing elastomer. The electroconductive composition according to the present invention may contain at least one of a block copolymer and a functional group-containing elastomer. and also may contain both a block copolymer and a functional group-containing elastomer.

[Block copolymer]

The term "block copolymer" refers to a copolymer having a molecular structure in which two or more kinds of polymers having different properties are covalently linked to form a long chain.

The block copolymer is preferably solid at least in a range of 20 to 30°C. Being solid in the above-mentioned temperature range is advantageous because it affords excellent tackiness to the composition that is formed into a dry film or that is applied to a substrate and tentatively dried.

The block copolymer preferably includes a soft segment and a hard segment. The term "soft segment" refers to a more flexible portion. On the other hand, the term "hard segment" refers to a more rigid portion.

Examples of block copolymers including a soft segment and a hard segment include a block copolymer represented by the below-mentioned formula (Ia):

$$X\text{-}Y \qquad \text{(Ia)}$$

(wherein, X is a polymer unit (hard segment) having a glass transition point $Tg_x$ of more than 30°C; and Y is a polymer unit (soft segment) having a glass transition point $Tg_y$ of less than 0°C).

Using a block copolymer represented by the formula (Ia) affords toughness to a cured product obtained from the electroconductive composition according to the present invention. In this regard, the glass transition point Tg is measured by differential scanning calorimetry (DSC).

In addition, examples of block copolymers include a block copolymer represented by the below-mentioned formula (I):

$$X_1\text{-}Y\text{-}X_2 \qquad \text{(I)}$$

(wherein, $X_1$ and $X_2$ independently represent a polymer unit having a glass transition point Tg of 0°C or more. Y represents a polymer unit having a glass transition point Tg of less than 0°C).

Preferably, $X_1$ and $X_2$ are polymer units having a Tg of 50°C or more, and Y is a polymer unit having a Tg of -20°C or less. The glass transition point Tg is measured by, for example, differential scanning calorimetry (DSC). In the formula I, $X_1$ and $X_2$ may be different polymer units, but are preferably the same polymer units.

In the block copolymer represented by the formula (I), it is preferable that Y having a smaller glass transition point Tg forms a soft segment and that X having a larger glass transition point Tg forms a hard segment.

In addition, the ratio of X to Y is preferably in a range of 20:80 to 50:50. X and Y being in the above-mentioned range is preferable because it allows the composition to follow the base material when elongated and thus makes it more difficult to cause breaking of wiring. It is more preferably 25:75 to 40:60. In this regard, when the block copolymer contains $X_1$ and $X_2$, the total amount of $X_1$ and $X_2$ is treated as X to calculate the ratio with respect to Y.

Between the above-mentioned formulae (Ia) and (I), the formula (I) is more preferable from the viewpoint of tensile elongation at break.

Examples of X, $X_1$, and $X_2$ include polymethyl(meth)acrylate (PMMA), polystyrene (PS), and the like. Examples of Y include poly-n-butylacrylate (PBA) and polybutadiene (PB). The block copolymer is preferably a polymethyl(meth)acrylate/poly-n-butyl (meth)acrylate/polymethyl(meth)acrylate triblock copolymer. As used herein, (meth)acrylate is a term that collectively refers to acrylate and methacrylate, and this applies to other similar expressions.

The block copolymer may be a commercially available product. Examples of commercially available products include acrylic triblock copolymers produced by Arkema K.K. using living polymerization. Specifically, SBM types exemplified by polystyrene-polybutadiene-polymethylmethacrylate, MAM types exemplified by polymethylmethacrylate-polybutylacrylate-polymethylmethacrylate, and MAM N types or MAM A types treated by carboxylic acid modification or treated by hydrophilic group modification are used. Examples of SBM types include E41, E40, E21, and E20. Examples of MAM types include M51, M52, M53, and M22. Examples of MAM N types include 52N and 22N. Examples of MAM A types include SM4032XM10. Examples of commercially available products include KURARITY™ made by Kuraray Co., Ltd. This KURARITY™ is a block copolymer derived from methyl methacrylate and butyl acrylate.

A block copolymer containing a (meth)acrylate polymer block, as above-mentioned, can be obtained by, for example, a method described in Japanese Unexamined Patent Application Publication (Translation of PCT Application) No. 2007-516326 or Japanese Unexamined Patent Application Publication (Translation of PCT Application) No. 2005-515281. In particular, the block copolymer can suitably be obtained by polymerizing Y units using, as an initiator, an alkoxyamine compound represented by any one of the below-mentioned formulae (1) to (4) and then polymerizing X units.

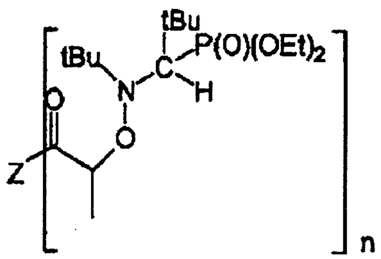

(1)

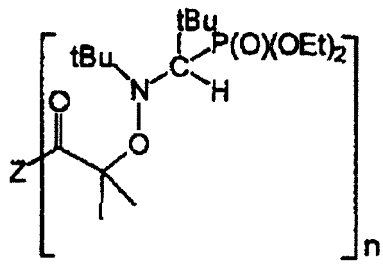

(2)

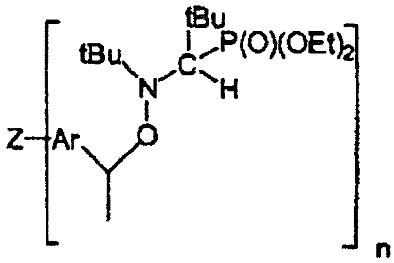

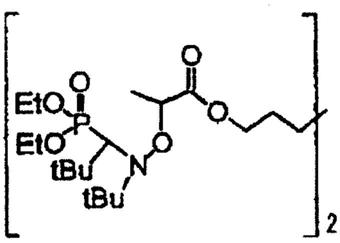

(3) (4)

(wherein, n represents 2; Z represents a bivalent organic group and is preferably selected from 1,2-ethanedioxy, 1,3-propanedioxy, 1,4-butanedioxy, 1,6-hexanedioxy, 1,3,5-tris(2-ethoxy)cyanuric acid, polyaminoamine, for example polyethyleneamine, 1,3,5-tris(2-ethylamino)cyanuric acid, polythioxy, phosphonate, and polyphosphonate; and Ar represents a bivalent aryl group.)

The weight average molecular weight of the block copolymer is preferably 20,000 to 400,000, more preferably 50,000 to 300,000. The weight average molecular weight being 20,000 or more can afford the effects of toughness and flexibility of interest, and afford excellent tackiness when the electroconductive composition is molded and dried in film form or is applied onto a substrate and then dried. In addition, the weight average molecular weight being 400,000 or less allows the electroconductive composition to have favorable viscosity and to achieve higher printability and processability. In addition, the weight average molecular weight being 50,000 or more can afford excellent effect in cushioning properties to external impact.

The block copolymer preferably has a tensile elongation at break of 100 to 600% as measured by the method in accordance with the international standard ISO 37 of the International Standardization Organization. The tensile elongation at break being 100 to 600% affords superior stretchability and electrical resistance stability to the conductor. It is more preferably 300 to 600%.

$$\text{tensile elongation at break (\%)} = (\text{elongation at break (mm)} - \text{initial dimensions mm}) / (\text{initial dimensions mm}) \times 100$$

The block copolymer may be used singly or in combination of two or more kinds thereof.

[Functional group-containing elastomer]

Containing a functional group-containing elastomer in the electroconductive composition according to the present invention improves the flexibility and cross-linkability of the obtained cured coating film and imparts further excellent solvent resistance thereto. Such a functional group-containing elastomer can be used without particular limitation as long as it is an elastomer having a functional group in the skeleton. Examples of functional group-containing elastomers include styrene elastomers, olefin elastomers, urethane elastomers, polyester elastomers, polyamide elastomers, acrylic elastomers, silicone elastomers, and the like each having a functional group. The functional group-containing elastomer also includes functional group-containing block copolymers. The block copolymer is as above described. In addition, elastomers containing, as a functional group, at least one of (meth)acryloyl groups, acid anhydride groups, carboxyl groups, and epoxy groups can be suitably used. Among these, urethane elastomers and olefin elastomers are preferable from the viewpoint of stretchability, those having a (meth)acryloyl group are preferable in terms of having excellent solvent resistance, and those having a plurality of (meth)acryloyl groups are particularly preferable.

As urethane elastomers having a plurality of (meth)acryloyl groups, examples of those having difunctional groups include: U-108A, UA-112P, UA-5201, UA-512, UA-412A, UA-4200, UA-4400, UA-340P, UA-2235PE, UA-160TM, UA-122P, UA-512, UA-W2, UA-7000, and UA-7100 made by Shin-Nakamura Chemical Co., Ltd.; CN962, CN963, CN964, CN965, CN980, CN981, CN982, CN983, CN996, CN9001, CN9002, CN9788, CN9893, CN978, CN9782, and CN9783 made by Sartomer Japan Inc.; M-1100, M-1200, M-1210, M-1310, and M-1600 made by Toagosei Co., Ltd.; UN-9000PEP, UN-9200A, UN-7600, UN-333, UN-1255, UN-6060PTM, UN-6060P, and SH-500B made by Negami Chemical Industrial Co., Ltd.; AH-600 and AT-600 made by Kyoeisha Chemical Co., Ltd.; EBECRYL280, EBECRYL284, EBECRYL402, EBECRYL8402, EBECRYL8411, EBECRYL8807, and EBECRYL9270 made by Daicel-Allnex Ltd.; and the like.

Examples of those having trifunctional groups include: CN929, CN944B85, CN989, and CN9008 made by Sartomer Japan Inc.; EBECRYL264, EBECRYL265, EBECRYL1259, EBECRYL8201, KRM8296, EBECRYL294/25HD,

and EBECRYL4820 made by Daicel-Allnex Ltd.; and the like. Examples of those having tetra- or more multi-functional groups include: U-6HA, U-6H, U-15HA, UA-32P, U-324A, and UA-7200 made by Shin-Nakamura Chemical Co., Ltd.; CN968, CN9006, and CN9010 made by Sartomer Japan Inc.; UN-3320HA, UN-3320HB, UN-3320HC, UN-3320HS, UN-904, UN-901T, UN-905, and UN-952 made by Negami Chemical Industrial Co., Ltd.; EBECRYL1290, EBECRYL1290K, KRM8200, EBECRYL5129, EBECRYL8210, EBECRYL8301, and EBECRYL8405 made by Daicel-Allnex Ltd.; and the like.

As specific examples of elastomers containing other functional groups, examples of those containing an acid anhydride group include RICON130MA8, RICON130MA13, RICON130MA20, RICON131MA5, RICON131MA10, RICON131MA17, RICON131MA20, RICON184MA6, and RICON156MA17 (which are the tradenames of products made by Sartomer Japan Inc.). In addition, examples of those having (meth)acryloyl groups include: US102 (made by Kuraray Co., Ltd.); CN301 and CN307 (which are the tradenames of products made by Sartomer Japan Inc.); BAC-45 (the tradename of products made by Osaka Organic Chemical Industry Ltd.); and the like. Further, as those having a carboxyl group, butadiene-acrylonitrile copolymers modified with carboxyl groups at both ends can be used. In addition, as those having an epoxy group and a carboxyl group, elastomers in which part or all of epoxy groups of an epoxy resin whose skeleton varies are modified with a butadiene-acrylonitrile copolymer modified with carboxylic acids at both ends can be used.

The functional group-containing elastomer may be used singly or in combination of two or more kinds thereof.

The blended amount of each of the block copolymer and the functional group-containing elastomer is preferably 5 to 30 mass% relative to all solid content contained in the electroconductive composition, and the total blended amount of the block copolymer and the functional group-containing elastomer in combination is preferably 10 to 30 mass%. In addition, for example, each blended amount is preferably 40 to 100 mass% relative to all masses of organic components in all solids, and the total blended amount of the block copolymer and the functional group-containing elastomer in combination is preferably 85 to 100 mass%. The blended amount being in the above-mentioned range affords more favorable stretchability to the formed coating.

[Chain-like silver powder]

As a chain-like silver powder in the present invention, a chain-like silver powder that is in the form of aggregate particles into which microparticles have aggregated and that has a tap density of 2.0 $g/cm^3$ or less is used. Herein, specific examples of chain-like silver powders include ramified branches of agglomerate silver powder or silver particles, i.e., a dendritic silver powder, and the like. The chain-like silver powder is preferably a chain-like silver powder in the form of aggregate particles into which 1 $\mu m$ or less microparticles have aggregated. The tap density is preferably 0.3 to 1.5 $g/cm^3$, more preferably 0.3 to 1.0 $g/cm^3$. Although the detailed mechanism is not clarified, it is probable that the tap density being 2.0 $g/cm^3$ or less results in a larger volume of silver powder and thus increases the number of contact points, thereby facilitating electroconduction. As a result, the conductor acquires an excellent resistance value even if it undergoes strong expansion and contraction. In this regard, the tap density in the present invention is measured at a tapping frequency of 1000 taps in accordance with IS03953.

Examples of the chain-like silver powder as a commercially available product include: SILVEST E-20 and K-03-1 made by Tokuriki Chemical Research Co., Ltd.; SILCOAT AgC-G and AgC-H by Fukuda Metal Foil & Powder Co., Ltd.; Ag-008 and Ag-030 made by Shoei Chemical Inc.; and the like.

The specific surface area of the chain-like silver powder measured in accordance with the BET method is preferably 1.0 to 5.0 $m^2/g$.

The chain-like silver powder preferably has an average particle size ($D_{50}$) of 3 to 15 $\mu m$ in accordance with a particle size distribution measurement method of a laser analysis scattering type.

The chain-like silver powder may be used singly or in combination of two or more kinds thereof. The blended amount of the chain-like silver powder is preferably 70 to 90 mass% with respect to all solid content contained in the electroconductive composition on a mass% basis. The blended amount being 70 mass% or more can easily afford a conductor having low resistance. The blended amount being 90 mass% or less does not easily cause breaking of wiring in extension and contraction. It is more preferably 72 to 86 mass%. In addition, the electroconductive composition according to the present invention may contain another electroconductive filler to the extent that the effects of the present invention are not impaired.

(Peroxide)

The electroconductive composition according to the present invention preferably has peroxide blended therein as a polymerization initiator, particularly when it contains a functional group-containing elastomer. Containing peroxide allows the composition to have excellent storage stability. Further, when the functional group-containing elastomer is an elastomer containing a radical-polymerizable functional group such as a (meth)acryloyl group, the elastomer starts

radical reaction. As a result, the elastomer is cured at low temperature in a short time, and can have an improved solvent resistance.

Examples of the peroxide include liquid peroxides and powder peroxides, and specific examples include the below-mentioned materials.

Ketone peroxide such as methylethylketone peroxide, cyclohexanone peroxide, and acetylacetone peroxide; peroxyketal such as 1,1-di(t-hexylperoxy)-3,3,5-trimethylcyclohexane, 1,1-di(t-hexylperoxy)cyclohexane, 1,1-di(t-butylperoxy)-2-methylcyclo hexane, and 1,1-di(t-butylperoxy)cyclohexane; peroxyketal such as 2,2-di(t-butylperoxy)butane, n-butyl 4,4-di-(t-butylperoxy)valerate, and 2,2-di(4,4-di-(t-butyl peroxy)cyclohexyl)propane; hydroperoxide such as p-menthane hydroperoxide, diisopropylbenzene hydroperoxide, 1,1,3,3-tetramethylbutyl hydroperoxide, cumene hydroperoxide, and t-butyl hydroperoxide; dialkyl peroxide such as di(2-t-butylperoxyisopropyl)benzene, dicumyl peroxide, 2,5-dimethyl-2,5-di(t-butylperoxy)hexane, t-butylcumyl peroxide, di-t-hexyl peroxide, di-t-butyl peroxide, and 2,5-dimethyl-2,5-di(t-butylperoxy)hexyne-3; diacyl peroxide such as, diisobutyl peroxide, di(3,5,5-trimethylhexanoyl)peroxide, dilauroyl peroxide, disuccinic acid peroxide, di-(3-methylbenzoyl)peroxide, benzoyl(3-methylbenzoyl)peroxide, dibenzoyl peroxide, and di-(4-methylbenzoyl)peroxide; peroxy dicarbonate such as di-n-propylperoxy dicarbonate, diisopropylperoxy dicarbonate, di(4-t-butylcyclohexyl)peroxy dicarbonate, di(2-ethylhexyl)peroxy dicarbonate, di-sec-butylperoxy dicarbonate; peroxy esters such as cumylperoxy neodecanoate, 1,1,3,3-tetramethylbutylperoxy neodecanoate, t-hexylperoxy neodecanoate, t-butylperoxy neodecanoate, t-butylperoxyneoheptanoate, t-hexylperoxypivalate, t-butylperoxypivalate, 1,1,3,3-tetramethylbutylperoxy-2-ethyl hexanoate, 2,5-dimethyl-2,5-di(2-ethylhexanoylperoxy)hexane, t-hexylperoxy-2-ethylhexanoate, t-butyl peroxy-2-ethylhexanoate, t-hexylperoxyisopropyl monocarbonate, t-butylperoxy maleic acid, t-butylperoxy-3,5,5-trimethylhexanoate, t-butylperoxy laurate, t-butylperoxyisopropyl monocarbonate, t-butylperoxy-2-ethylhexyl monocarbonate, t-hexylperoxy benzoate, 2,5-dimethyl-2,5-di(benzoylperoxy)hexane, t-butylperoxy acetate, t-butylperoxy-3-methyl benzoate, t-butylperoxy benzoate, and t-butylperoxyallyl monocarbonate; and 3,3',4,4'-tetra (t-butylperoxycarbonyl)benzophenone.

Among such peroxides, those in liquid form are preferably used. The use of liquid peroxides can afford electroconductive compositions that also have excellent storage stability. Here, the term "liquid peroxide" refers to a peroxide that is in liquid form at room temperature (25°C) at atmospheric pressure.

Examples of liquid peroxides include: ketone peroxide such as methylethylketone peroxide, cyclohexanone peroxide, and acetylacetone peroxide; peroxyketal such as 1,1-di(t-hexylperoxy)-3,3,5-trimethylcyclohexane, 1,1-di(t-hexylperoxy)cyclohexane, 1,1-di(t-butylperoxy)-2-methylcyclo hexane, and 1,1-di(t-butylperoxy)cyclohexane; peroxyketal such as 2,2-di(t-butylperoxy)butane, n-butyl 4,4-di-(t-butylperoxy)valerate, and 2,2-di(4,4-di-(t-butyl peroxy)cyclohexyl)propane; hydroperoxide such as p-menthane hydroperoxide, diisopropylbenzene hydroperoxide, 1,1,3,3-tetramethylbutyl hydroperoxide, cumene hydroperoxide, and t-butyl hydroperoxide; dialkyl peroxide such as 2,5-dimethyl-2,5-di(t-butylperoxy)hexane, t-butylcumyl peroxide, di-t-hexyl peroxide, di-t-butyl peroxide, and 2,5-dimethyl-2,5-di(t-butylperoxy)hexyne-3; diacyl peroxide such as, diisobutyl peroxide, di(3,5,5-trimethylhexanoyl)peroxide, di-(3-methylbenzoyl)peroxide, benzoyl(3-methylbenzoyl)peroxide, and dibenzoyl peroxide; peroxy dicarbonate such as di-n-propylperoxy dicarbonate, diisopropylperoxy dicarbonate, di(2-ethylhexyl)peroxy dicarbonate, di-sec-butylperoxy dicarbonate; peroxy esters such as cumylperoxy neodecanoate, 1,1,3,3-tetramethylbutylperoxy neodecanoate, t-hexylperoxy neodecanoate, t-butylperoxy neodecanoate, t-butylperoxyneoheptanoate, t-hexylperoxypivalate, t-butylperoxypivalate, 1,1,3,3-tetramethylbutylperoxy-2-ethyl hexanoate, 2,5-dimethyl-2,5-di(2-ethylhexanoylperoxy)hexane, t-hexylperoxy-2-ethylhexanoate, t-butyl peroxy-2-ethylhexanoate, t-hexylperoxyisopropyl monocarbonate, t-butylperoxy-3,5,5-trimethylhexanoate, t-butylperoxy laurate, t-butylperoxyisopropyl monocarbonate, t-butylperoxy-2-ethylhexyl monocarbonate, t-hexylperoxy benzoate, t-butylperoxy acetate, t-butylperoxy-3-methyl benzoate, t-butylperoxy benzoate, and t-butylperoxyallyl monocarbonate; and 3,3',4,4'-tetra (t-butylperoxycarbonyl)benzophenone.

Among those, peroxides preferable in the present invention include: peroxyketal such as 1,1-di(t-hexyl peroxy)-3,3,5-trimethylcyclohexane, 1,1-di(t-hexylperoxy)cyclohexane, and n-butyl-4,4-di-(t-butylperoxy)valerate; hydroperoxide such as 1,1,3,3-tetramethylbutyl hydroperoxide; dialkyl peroxide such as 2,5-dimethyl-2,5-di(t-butylperoxy)hexane, t-butylcumyl peroxide, di-t-hexyl peroxide, di-t-butyl peroxide, 2,5-dimethyl-2,5-di(t-butylperoxy)3-hexyne; and peroxy esters such as diacyl peroxide, peroxy carbonate, 1,1,3,3-tetramethylbutylperoxy-2-ethyl hexanoate, t-hexylperoxy-2-ethyl hexanoate, t-butylperoxy-2-ethyl hexanoate, t-hexylperoxyisopropyl monocarbonate, t-butylperoxy-3,3,5-trimethyl hexanoate, t-butylperoxy laurate, t-butylperoxy-2-ethylhexyl monocarbonate, t-hexylperoxy benzoate, t-butylperoxy-3-methyl benzoate, and t-butylperoxy benzoate. Further among the above-mentioned particularly preferable peroxides, the use of peroxy esters can afford excellent adhesiveness. Among those peroxy esters, the use of alkylperoxy esters having the below-mentioned structure is preferable because it can afford extremely excellent solvent resistance, and 1,1,3,3-tetramethylbutylperoxy-2-ethyl hexanoate is more preferable.

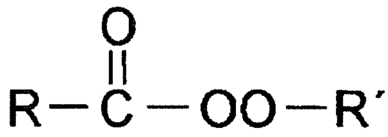

(wherein R and R' independently represent alkyl group.)

As peroxides such as described above, those having a one-minute half-life temperature of 80 to 200°C, preferably 85 to 180°C, are used preferably. The one-minute half-life temperature being 80°C or more allows sufficient usable life to be secured in use at room temperature. The one-minute half-life temperature being 200°C or less allows sufficient curability to be secured.

The peroxide may be used singly or in combination of a plurality of kinds thereof.

(Organic solvent)

Furthermore, for the electroconductive composition according to the present invention, an organic solvent can be used in order to adjust the composition or adjust the viscosity suitable for application to the substrate.

Examples of such organic solvents include ketones, aromatic hydrocarbons, glycol ethers, glycol ether acetates, esters, alcohols, aliphatic hydrocarbons, petroleum solvents, and the like. More specific examples include: ketones such as methylethyl ketone and cyclohexanone; aromatic hydrocarbons such as toluene, xylene, and tetramethyl benzene; glycol ethers such as cellosolve, methyl cellosolve, butyl cellosolve, carbitol, methyl carbitol, butyl carbitol, propylene glycol monomethyl ether, dipropylene glycol monomethyl ether, dipropylene glycol diethyl ether, and triethylene glycol monoethyl ether; esters such as ethyl acetate, butyl acetate, diethylene glycol monoethyl ether acetate, dipropylene glycol methyl ether acetate, propylene glycol methyl ether acetate, propylene glycol ethyl ether acetate, and propylene glycol butyl ether acetate; alcohols such as ethanol, propanol, ethylene glycol, and propylene glycol; aliphatic hydrocarbons such as octane and decane; petroleum solvents such as petroleum ether, petroleum naphtha, hydrogenated petroleum naphtha, and solvent naphtha. Such organic solvents are used singly or in mixture of two or more kinds thereof. Among those diethylene glycol monoethyl ether acetate is preferable from the viewpoint of coating properties.

(Sulfur compound)

By containing a certain amount of sulfur component, the electroconductive composition according to the present invention further has excellent adhesiveness to stretchable substrates and flexibility, and thus a sulfur compound is preferably blended. As sulfur compounds, known and common substances can be used, and examples thereof include thiodiglycolic acid and the like.

The electroconductive composition according to the present invention may further contain a thermosetting component. Examples of thermosetting components include polyester resins (e.g. urethane modified products, epoxy modified products, acryl modified products, and the like), epoxy resins, urethane resins, phenol resins, melamine resins, vinyl resins, and silicone resins, which can each be formed into films by molecular weight increase and cross linking caused by curing reaction.

The electroconductive composition according to the present invention may contain other components. For example, the electroconductive composition may contain an additive such as a thermoplastic resin, a coupling agent, a photopolymerization initiator, and a dispersing agent.

The electroconductive composition according to the present invention can be produced by kneading a silver powder and at least one selected from a block copolymer and a functional group-containing elastomer, which are dissolved in a solvent. As a kneading method, there is, for example, a method using a stirring and mixing machine such as a roll mill.

Using the electroconductive composition according to the present invention can afford a conductor having excellent stretchability and electrical resistance stability without containing a conjugated double bond polymer such as PEDOT (poly(3,4-ethylene dioxythiophene)) which is an electroconductive polymer.

Using the electroconductive composition according to the present invention not only can afford a conductor having excellent stretchability and electrical resistance stability but also allows an electroconductive cured product to be formed by heat treatment at low temperature and also can afford a conductor having high adhesiveness to heat-sensitive substrates. In addition, the use of the above-mentioned chain-like silver powder improves printability.

The electroconductive composition according to the present invention can suitably be used to form conductors for wearable devices such as extracorporeal devices, body surface devices, electronic skin devices, and intracorporeal devices. In addition, the electroconductive composition according to the present invention can suitably be used for electrodes of flexible printed boards. Further, the electroconductive composition according to the present invention is

suitable for forming a conductor formed on a substrate such as a film substrate (for example, a polarizing plate included in a member of a liquid crystal panel) that is heat-sensitive and expands and contracts with heat. It is also suitable for forming a conductor such as an actuator electrode. In addition, it is suitable for forming a conductor having a design that is conventionally difficult to achieve because of insufficient stretchability and electrical resistance stability.

The conductor according to the present invention is characterized by being obtained from the above-mentioned electroconductive composition. The conductor may be one obtained by the heat treatment of the electroconductive composition. An example of heat treatment is drying or thermosetting. Heat treatment may be preceded by molding. For example, the conductor is obtained by the heat treatment of the above-mentioned electroconductive composition applied on a substrate.

The conductor may be of various shapes in accordance with the applications for which it is used. Examples of conductors include conductor circuits and wiring.

The production of conductor circuits involves: a pattern formation step in which the above-mentioned electroconductive composition is printed on or applied to a substrate to form a coating film pattern; and a heat treatment step in which the coating film pattern is heat-treated. In addition, the production may include a photo-curing step in place of the heat treatment process or in addition to the heat treatment step. For the formation of a coating film pattern, a masking method, a method using resist, and the like can be used.

Examples of the pattern formation step include a printing method and a dispensing method. Examples of the printing methods include gravure printing, offset printing, screen printing, and the like, and for the formation of microfabricated circuits, the screen printing is preferable. In addition, as a large area application method, the gravure printing and the offset printing are suitable. The dispensing method is a method in which an electroconductive composition is extruded through needles in a controlled amount of application to form a pattern and which is suitable for partially forming a pattern such as grounding wiring or for forming a pattern on a rough portion.

In the heat treatment step, treatment can be carried out in accordance with the substrate used at a temperature of, for example, 80 to 150°C or 150 to 200°C. The temperature in the heat treatment step is preferably 70 to 120°C, more preferably 80 to 100°C. The time for the heat treatment step is preferably 15 to 90 minutes, more preferably 30 to 75 minutes.

Examples of substrates include printed wiring boards with preformed circuits and flexible printed wiring boards. In addition, examples of substrate materials include; copper-clad layered plates of all grades (such as FR-4) using composites such as paper-phenol resin, paper-epoxy resin, glass fabric-epoxy resin, glass-polyimide, glass fabric/nonwoven fabric-epoxy resin, glass fabric/paper-epoxy resin, synthetic fiber-epoxy resin, fluorine resin-polyethylene-polyphenylene ether, and polyphenylene oxide-cyanate ester; polyesters such as polyethylene terephthalate (PET), polybutylene terephthalate, and polyethylene naphthalate; sheets or films composed of plastics such as polyimide, polyphenylene sulfide, and polyamide; sheets or films composed of cross-linking rubbers such as urethane, silicon rubber, acryl rubber, and butadiene rubber; sheets or films composed of thermoplastic elastomers such as polyester-based, polyurethane-based, polyolefin-based, and styrene block copolymer-based elastomers; and the like.

In addition, the conductor according to the present invention can suitably be used for stretchable substrates. As stretchable substrates, non-cross-linked elastomers or fibers; or elastomers cross-linked with a cross-linking agent, or fibers, in which the elastomer or the fiber is at least any one of fluorine rubber, silicone rubber, nitrile rubber, acryl rubber, styrene rubber, chloroprene rubber, urethane rubber, butyl rubber, ethylene rubber, propylene rubber, ethylene propylene rubber, natural rubber, and composites of two or more thereof are suitably used. Examples of the non-cross-linked elastomers include thermoplastic polyurethane elastomers.

## EXAMPLES

Below, the present invention will be specifically described with reference to Examples, but the present invention is not to be limited thereto. Hereunder, "part(s)" and "%" are on a mass basis, unless otherwise specified.

[Examples 1-1 to 1-11, Comparative Examples 1-1 to 1-4]

(Preparation of electroconductive composition)

Block copolymers: LA2330 and LA2250 (which are each an X-Y-X block copolymer) made by Kuraray Co., Ltd., were dissolved respectively in diethylene glycol monoethyl ether acetate as a solvent, to make resin solutions having a solid content of 50 mass%. These resin solutions were blended with various silver powders, preliminarily stirred and mixed using a stirrer, and then kneaded using a three-roll mill to obtain the respective electroconductive compositions of Examples 1-1 to 1-9 and Comparative Examples 1-2 to 1-4. In Comparative Example 1-1, VYLON®290 was used for making a 30 mass% resin solution in the same manner as described above, to obtain a resin composition.

A functional group-containing elastomer EBECRYL8402 made by Daicel-Allnex Ltd., a monomer M5700 made

by Toagosei Co., Ltd., the above-mentioned resin solution of LA2330, and a chain-like silver powder were blended, preliminarily stirred and mixed using a stirrer, then kneaded using a three-roll mill, followed by adding PEROCTA® O lastly and stirring, to obtain electroconductive compositions for Examples 1-10 to 1-11.

(Measurement of X:Y composition ratio of block copolymer)

The block copolymer was measured for $^1$H NMR, and the composition ratio of the copolymer was calculated. The X to Y ratio of LA2330 was X:Y = 25:75, and that of LA2250 was X:Y = 34:66.

(Measurement of tap density of silver powder)

The silver powders described in the Tables below were measured for tap density in accordance with ISO3953. The measurements were made at a tapping frequency of 1000 taps.

(Measurement of specific resistance)

After each electroconductive composition was applied to a substrate by screen printing, the pieces with the electroconductive compositions of Examples 1-1 to 1-9 and Comparative Examples 1-1 to 1-4 applied respectively were heat-treated at 80°C for 30 minutes, and the pieces with the electroconductive compositions of Examples 1-10 and 1-11 applied respectively were heat-treated at 100°C for 30 minutes, to obtain conductors. As a substrate, a PET film was used. Both ends of the obtained conductor were measured for resistance by the four-terminal method, and further measured for line width, line length, and thickness, to determine the specific resistance (volume resistivity).

(Maximum resistance in 20% stretching test)

The electroconductive compositions of Examples 1-1 to 1-6 and Comparative Examples 1-1 to 1-4 were each applied to a substrate by screen printing, and were heat-treated at 80°C for 30 minutes, to form conductors of 1 mm in line width, 20 μm in thickness, and 40 mm in length on the substrate. As a substrate, a urethane film (TG88-I, 70 μm in thickness, made by Takeda Sangyo Corporation) was used. To measure resistance, 20% stretching was applied onto the conductor in the 2.5% stretched state (having no flexure), and this was repeated 100 times reciprocatively in 250 seconds. The maximum resistances during this are shown in Tables 1 and 4.

(Breaking of wiring in 50% stretching test)

The electroconductive compositions of Examples 1-1 to 1-6 and Comparative Examples 1-1 to 1-4 were each applied to a substrate by screen printing, and were heat-treated at 80°C for 30 minutes, to form conductors of 1 mm in line width, 20 μm in thickness, and 40 mm in length on the substrate. As a substrate, a urethane film (TG88-I, 70 μm in thickness, made by Takeda Sangyo Corporation) was used. To evaluate breaking of wiring, 50% stretching was applied onto the conductor in the 0% elongated state, and this was repeated 100 times reciprocatively in 700 seconds. The results are shown in Tables 1 and 4.

(Breaking of wiring in 50% elongation test)

After each electroconductive composition was applied to a substrate by screen printing, the pieces with the electroconductive compositions of Examples 1-1 to 1-9 and Comparative Examples 1-1 to 1-4 applied respectively were heat-treated at 80°C for 30 minutes, and the pieces with the electroconductive compositions of Examples 1-10 and 1-11 applied respectively were heat-treated at 100°C for 30 minutes, to form conductors of 1 mm in line width, 20 μm in thickness, and 40 mm in length on the substrate. As a substrate, a urethane film (ES85, 100 μm in thickness, made by Okura Industrial Co., Ltd.) was used. To measure resistance, the test piece was elongated 10% at a rate of 5 mm/second, and then held for 60 seconds. This was repeated until the test piece was 50% elongated, and then evaluated for breaking of wiring at the 50% elongation. The results are shown in Tables 1 to 4. The criterion for breaking of wiring was 1 MΩ or more.

(Resistance at 400% elongation)

The electroconductive compositions of Example 1-2 and Comparative Example to 1-4 were each applied to a substrate by screen printing, and were heat-treated at 80°C for 30 minutes, to form conductors of 1 mm in line width, 20 μm in thickness, and 40 mm in length on the substrate. As a substrate, a urethane film (TG88-I, 70 μm in thickness,

made by Takeda Sangyo Corporation) was used. To measure resistance, the test piece was elongated 25% at a rate of 5 mm/second, and then held for 15 seconds. This was repeated until the test piece was 400% elongated. The results are shown in Tables 1 and 4. FIG. 1 shows a graph depicting the relationship between elongation and resistance of the electroconductive composition in Example 1-2 and Comparative Example 1-4.

[Table 1]

| | | | Examples | | | | | |
|---|---|---|---|---|---|---|---|---|
| | | | 1-1 | 1-2 | 1-3 | 1-4 | 1-5 | 1-6 |
| Binder | Block copolymer | LA2330*1 | 26 | 20 | 14 | 11 | - | 20 |
| | | LA2250*2 | - | - | - | - | 20 | - |
| | Polyester | VYLON®290*3 | - | - | - | - | - | - |
| Silver powder | Chain-like | AgC-G*4 | 74 | 80 | 86 | 89 | 80 | - |
| | | E-20*5 | - | - | - | - | - | 80 |
| | Flaky | AgC-A*6 | - | - | - | - | - | - |
| | | XF301*7 | - | - | - | - | - | - |
| | Spherical | C0083P*8 | - | - | - | - | - | - |
| X:Y composition ratio of block copolymer | | | 25:75 | 25:75 | 25:75 | 25:75 | 34:66 | 25:75 |
| Tap density (g/cm$^3$) of silver powder | | | 1.3 | 1.3 | 1.3 | 1.3 | 1.3 | 0.7 |
| Volume resistivity ($\Omega$·cm) | | | 5.0E-04 | 1.2E-04 | 2.0E-04 | 2.4E-04 | 1.5E-04 | 3.1E-04 |
| Maximum resistance in 20% stretching test ($\Omega$) | | | 320 | 120 | 61 | 52 | 60 | 45 |
| Breaking of wiring in 50% stretching test | | | no | no | no | no | no | no |
| Breaking of wiring in 50% elongation test | | | no | no | no | no | no | no |
| Resistance at 400% elongation | | | -*9 | conductive | -*9 | -*9 | -*9 | -*9 |

*1: a resin solution of LA2330 (tensile elongation at break: 490%) made by Kuraray Co., Ltd., as adjusted as above-mentioned. The blended amounts in Tables show the blended amounts of block copolymers (solid contents).
*2: a resin solution of LA2250 (tensile elongation at break: 380%) made by Kuraray Co., Ltd., as adjusted as above-mentioned. The blended amounts in Tables show the blended amounts of block copolymers (solid contents).
*3: a resin solution of VYLON® 290 made by Toyobo Co., Ltd. The blended amounts in Tables show the blended amounts of polyesters (solid contents).
*4: SILCOAT AgC-G (tap density: 1.3 g/cm$^3$, average particle size: 4.2 $\mu$m) made by Fukuda Metal Foil & Powder Co., Ltd.
*5: SILVEST® E-20 (tap density: 0.7 g/cm$^3$, average particle size: 10 $\mu$m) made by Tokuriki Chemical Research Co., Ltd.
*6: SILCOAT AgC-A (tap density: 3.3 g/cm$^3$, average particle size: 3.5 $\mu$m) made by Fukuda Metal Foil & Powder Co., Ltd.
*7: Ag-XF301 (tap density: 1.1 g/cm$^3$, average particle size: 5.2 $\mu$m) made by Fukuda Metal Foil & Powder Co., Ltd.
*8: C0083P (tap density: 2.7 g/cm$^3$, average particle size: 1.4 $\mu$m) made by Metalor Technologies
*9: "-" means "not evaluated".

[Table 2]

| | | | Examples | | |
|---|---|---|---|---|---|
| | | | 1-7 | 1-8 | 1-9 |
| Binder | Block copolymer | LA2330*1 | 25 | 25 | - |
| | | LA2250*2 | - | - | 25 |
| | Polyester | VYLON®290*3 | - | - | - |

(continued)

| | | | Examples | | |
|---|---|---|---|---|---|
| | | | 1-7 | 1-8 | 1-9 |
| Silver powder | Chain-like | AgC-G*4 | 75 | - | - |
| | | E-20*5 | - | 75 | 75 |
| | Flaky | AgC-A*6 | - | - | - |
| | | XF301*7 | - | - | - |
| | Spherical | C0083P*8 | - | - | - |
| X:Ycomposition ratio of block copolymer | | | 25:75 | 25:75 | 34:66 |
| Tap density (g/cm$^3$) of silver powder | | | 1.3 | 0.7 | 0.7 |
| Volume resistivity (Ω·cm) | | | 5.0E-04 | 1.9E-04 | 1.4E-04 |
| Breaking of wiring in 50% elongation test | | | no | no | no |

[Table 3]

| | | | Examples | |
|---|---|---|---|---|
| | | | 1-10 | 1-11 |
| Binder | Block copolymer | LA2330*1 | - | 10 |
| | Functional group-containing elastomer | EBECRYL8402*10 | 10 | 10 |
| | Monomer | M5700*11 | 10 | - |
| Chain-like silver powder | | AgC-G*4 | 80 | 80 |
| Additive | PEROCTA® O*12 | | 2 | 2 |
| | IRGACURE907*13 | | 1 | 1 |
| | Thiodiglycolic acid*14 | | 0.15 | 0.15 |
| | Silane coupling agent *15 | | 0.2 | 0.2 |
| X:Ycomposition ratio of block copolymer | | | - | 25:75 |
| Tap density(g/cm$^3$) of silver powder | | | 1.3 | 1.3 |
| Volume resistivity (Q·cm) | | | 1.5E-04 | 4.0E-04 |
| Breaking of wiring in 50% elongation test | | | no | no |

*10: urethane acrylate EBECRYL8402 made by Daicel-Allnex Ltd.
*11: acrylate monomer M5700 (2-hydroxy-3-phenoxy acrylate) made by Toagosei Co., Ltd.
*12: PEROCTA O (organic peroxide: 1,1,3,3-tetramethylbutylperoxy-2-ethylhexanoate) made by NOF Corporation
*13: IRGACURE907 (2-methyl-1-(4-methylthiophenyl)-2-morpholinopropane-1-one) made by BASF Japan Co., Ltd.
*14: 2,2'-thiodiglycolic acid made by Kanto Chemical Co., Inc.
*15: a silane coupling agent KBM-403 (3-glycidoxypropyltrimethoxy silane) made by Shin-Etsu Chemical Co., Ltd.

[Table 4]

| | | | Comparative Examples | | | |
|---|---|---|---|---|---|---|
| | | | 1-1 | 1-2 | 1-3 | 1-4 |
| Binder | Block copolymer | LA2330*1 | - | 11 | 11 | 33 |
| | | LA2250*2 | - | - | - | - |
| | Polyester | VYLON®290*3 | 20 | - | - | - |

(continued)

| | | | Comparative Examples | | | |
|---|---|---|---|---|---|---|
| | | | 1-1 | 1-2 | 1-3 | 1-4 |
| Silver powder | Chain-like | AgC-G*4 | 80 | - | - | - |
| | | E-20*5 | - | - | - | - |
| | Flaky | AgC-A*6 | - | - | 89 | - |
| | | XF301 *7 | - | - | - | 67 |
| | Spherical | C0083P*8 | - | 89 | - | - |
| X:Ycomposition ratio of block copolymer | | | - | 25:75 | 25:75 | 25:75 |
| Tap density (g/cm$^3$) of silver powder | | | 1.3 | 2.7 | 3.3 | 1.1 |
| Volume resistivity (Ω·cm) | | | 3.3E-04 | 5.5E-05 | 4.1E-05 | 9.0E-05 |
| Maximum resistance in 20% stretching test (92) | | | Breaking of wiring | 410 | 785 | 1400 |
| Breaking of wiring in 50% stretching test | | | yes | yes | yes | yes |
| Breaking of wiring in 50% elongation test | | | yes | yes | yes | yes |
| Resistance at 400% elongation | | | -*9 | -*9 | -*9 | Breaking of wiring |

The results shown in the above-mentioned Tables 1 to 3 have revealed that the conductors obtained from the electroconductive compositions of Examples have excellent stretchability and electrical resistance stability. In contrast, the conductor obtained from Comparative Example 1-1 using polyester has poorer stretchability, as shown. In addition, the conductors obtained from Comparative Examples 1-2 to 1-4 using flaky or spherical silver powder have poorer stretchability and electrical resistance stability, as shown.

[Examples 2-1 to 2-3, Comparative Example 2-1]

(Preparation of electroconductive composition)

Each of the functional group-containing elastomers, i.e., UC-102 made by Kuraray Co., Ltd., CN965 made by Sartomer Japan Inc., and EBECRYL8411 made by Daicel-Allnex Ltd.; diethylene glycol monoethyl ether acetate as an organic solvent; and a chain-like silver powder were blended, preliminarily stirred and mixed using a stirrer, then kneaded using a three-roll mill, followed by adding PEROCTA® O lastly and stirring, to obtain electroconductive compositions for Examples 2-1 to 2-3.

A thermoplastic resin VYLON®290 made by Toyobo Co., Ltd. was dissolved in diethylene glycol monoethyl ether acetate as an organic solvent, to make a resin solution having a solid content of 28.6 mass%. This resin solution was blended with a chain-like silver powder, preliminarily stirred and mixed using a stirrer, and then kneaded using a three-roll mill, followed by adding PEROCTA® O lastly and stirring, to obtain the electroconductive composition of Comparative Example 2-1.

(Measurement of tap density of silver powder)

The silver powder described in the below-mentioned Table 5 was measured for tap density in accordance with IS03953 in the same manner as described above. The measurements were made at a tapping frequency of 1000 taps.

(Measurement of specific resistance)

The electroconductive compositions were each applied to a substrate by screen printing and heat-treated at 130°C for 30 minutes to obtain conductors. As a substrate, a PET film was used. Both ends of the obtained conductor were measured for resistance by the four-terminal method, and further measured for line width, line length, and thickness, to determine the specific resistance (volume resistivity). The results are shown in Table 5.

(Stretchability and electrical resistance stability)

The electroconductive compositions were each applied to a substrate by screen printing, and were heat-treated at 130°C for 30 minutes, to form conductors of 1 mm in line width, 20 μm in thickness, and 40 mm in length on the substrate. As a substrate, a urethane film (TG88-I, 70 μm in thickness, made by Takeda Sangyo Corporation) was used. The electroconductivity was determined at the 20% stretching, and evaluated on the following criteria. The results are shown in Table 5.

○: no breaking of wiring at 20% elongation
Δ: breaking of wiring remaining at 20% elongation; no breaking of wiring when back to no elongation
×: breaking of wiring remaining at 20% elongation; breaking of wiring remaining when back to no elongation

(Solvent resistance)

The electroconductive compositions were each applied to a substrate by screen printing, and were heat-treated at 130°C for 30 minutes, to form conductors of 1 mm in line width, 20 μm in thickness, and 40 mm in length on the substrate. As a substrate, a PET film was used. When the obtained conductor was rubbed 10 times with a swab saturated with propylene glycol monomethyl ether acetate, the conductor was observed and evaluated on the following criteria. The results are shown in Table 5.

○: no change
Δ: partly dissolved
×: wholly dissolved

[Table 5]

| | | Example 2-1 | Example 2-2 | Example 2-3 | Comparative Example 2-1 |
|---|---|---|---|---|---|
| Functional group-containing elastomer | UC-102*16 | 20 | - | - | - |
| | CN965*17 | - | 20 | - | - |
| | EBECRYL8411*18 | - | - | 20 | - |
| Thermoplastic resin | Resin solution of VYLON®290*19 | - | - | - | 70 |
| Peroxide | PEROCTA® O*12 | 0.2 | 0.2 | 0.2 | 0.2 |
| Chain-like Silver powder | AgC-G*4 | 80 | 80 | 80 | 80 |
| Organic solvent*20 | | 10 | 10 | 10 | - |
| Tap density (g/cm$^3$) of chain-like silver powder | | 1.3 | 1.3 | 1.3 | 1.3 |
| Volume resistivity (Ω·cm) | | 4.3E-04 | 3.6E-04 | 3.5E-04 | 7.0E-05 |
| Stretchability and electrical resistance stability | | ○ | ○ | ○ | × |
| Solvent resistance | | ○ | ○ | ○ | × |

*16: KURAPRENE® UC-102 (liquid polyisoprene rubber (methacrylated)) made by Kuraray Co., Ltd.
*17: CN965 (polyester urethane acrylate) made by Sartomer Japan Inc.
*18: EBECRYL8411 (aliphatic urethane acrylate) made by Daicel-Allnex Ltd.
*19: a resin solution of VYLON®290 (amorphous polyester resin) made by Toyobo Co., Ltd. (having a solid content of 28.6 mass%)
*20: diethylene glycol monoethyl ether acetate

The results shown in the above-mentioned Table 5 have revealed that the conductors obtained from the electroconductive compositions of Examples have excellent stretchability and electrical resistance stability and also have excellent solvent resistance. In contrast, the electroconductive composition containing a thermoplastic resin in Comparative Example 2-1 has poorer solvent resistance.

[Examples 3-1 to 3-9]

With the electroconductive compositions of Examples 1-1 to 1-9, 0.15 parts by mass of thiodiglycolic acid (2,2'-thiodiglycolic acid made by Kanto Chemical Co., Inc.) and 0.2 parts by mass of a silane coupling agent (a silane coupling agent KBM-403 (3-glycidoxypropyltrimethoxy silane) made by Shin-Etsu Chemical Co., Ltd.) were further blended to obtain the electroconductive compositions of Example 3-1 to 3-9 respectively. The conductors obtained from the electroconductive compositions of Examples 1-10 and 1-11 and Examples 3-1 to 3-9 not only have excellent stretchability and electrical resistance stability but also have excellent adhesiveness to stretchable substrates and flexibility.

## Claims

1. An electroconductive composition comprising:

   at least one selected from a block copolymer and a functional group-containing elastomer; and
   a chain-like silver powder in the form of aggregate particles into which microparticles have aggregated,
   wherein the chain-like silver powder has a tap density of 2.0 g/cm$^3$ or less.

2. The electroconductive composition according to claim 1, wherein the block copolymer is a block copolymer represented by the below-mentioned formula (I):

   $$X_1\text{-}Y\text{-}X_2 \qquad (I)$$

   (wherein, $X_1$ and $X_2$ independently represent a polymer unit having a glass transition point Tg of 0°C or more; and Y represents a polymer unit having a glass transition point Tg of less than 0°C).

3. The electroconductive composition according to claim 1, wherein the block copolymer is a polymethyl(meth)acrylate/poly-n-butyl (meth)acrylate/polymethyl(meth)acrylate triblock copolymer.

4. The electroconductive composition according to claim 1, wherein the block copolymer has a tensile elongation at break of 300 to 600%.

5. The electroconductive composition according to claim 1, wherein the chain-like silver powder is a chain-like silver powder in the form of aggregate particles into which 1 μm or less microparticles have aggregated.

6. The electroconductive composition according to claim 1, wherein the blended amount of the chain-like silver powder is 70 to 90 mass% with respect to all solid content contained in the electroconductive composition.

7. A conductor obtained from the electroconductive composition according to any one of claims 1 to 6.

8. A flexible printed wiring board comprising a patterned conductor formed on an elastomer sheet using the electroconductive composition according to any one of claims 1 to 6.

FIG. 1

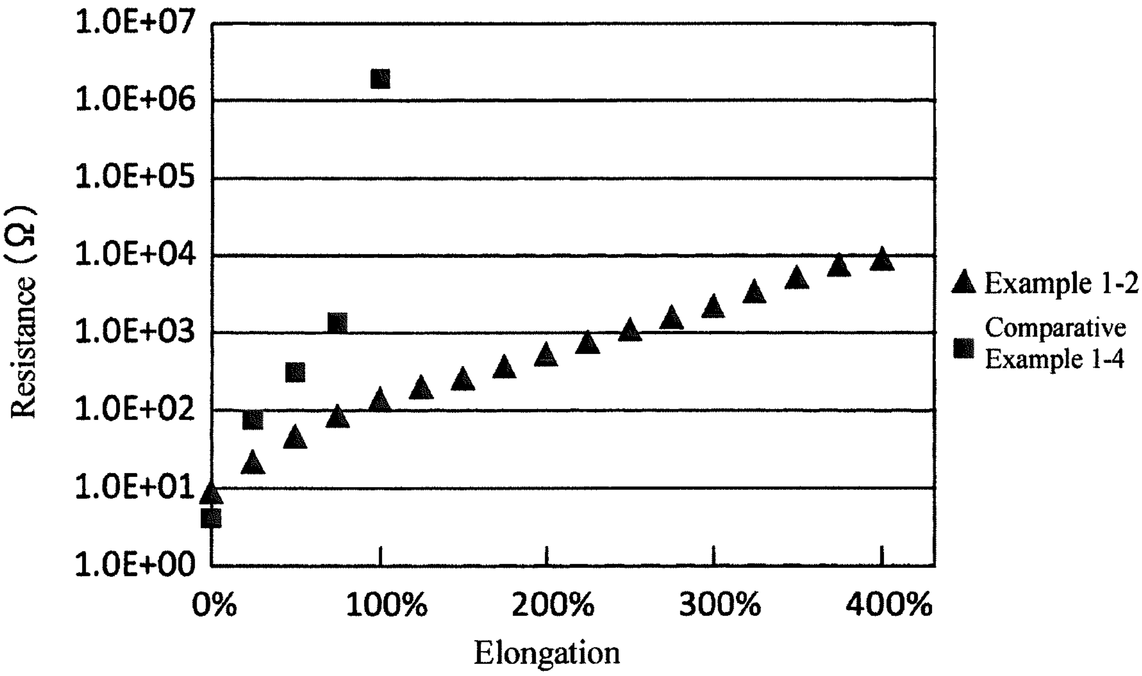
1.0E+07
1.0E+06
1.0E+05
1.0E+04
1.0E+03
1.0E+02
1.0E+01
1.0E+00
Resistance (Ω)
0%
100%
200%
300%
400%
Elongation
Example 1-2
Comparative Example 1-4

**INTERNATIONAL SEARCH REPORT**

International application No. PCT/JP2016/073204

A. CLASSIFICATION OF SUBJECT MATTER
*C08L53/00*(2006.01)i, *C08K3/08*(2006.01)i, *C08L21/00*(2006.01)i, *C08L33/06*(2006.01)i, *H01B1/00*(2006.01)i, *H01B1/22*(2006.01)i, *H01B5/14*(2006.01)i

According to International Patent Classification (IPC) or to both national classification and IPC

B. FIELDS SEARCHED

Minimum documentation searched (classification system followed by classification symbols)
C08L53/00, C08K3/08, C08L21/00, C08L33/06, H01B1/00, H01B1/22, H01B5/14

Documentation searched other than minimum documentation to the extent that such documents are included in the fields searched

| | | | |
|---|---|---|---|
| Jitsuyo Shinan Koho | 1922-1996 | Jitsuyo Shinan Toroku Koho | 1996-2016 |
| Kokai Jitsuyo Shinan Koho | 1971-2016 | Toroku Jitsuyo Shinan Koho | 1994-2016 |

Electronic data base consulted during the international search (name of data base and, where practicable, search terms used)

C. DOCUMENTS CONSIDERED TO BE RELEVANT

| Category* | Citation of document, with indication, where appropriate, of the relevant passages | Relevant to claim No. |
|---|---|---|
| X | JP 2004-043704 A (Three Bond Co., Ltd.), 12 February 2004 (12.02.2004), claims; paragraphs [0015] to [0025] (Family: none) | 1-8 |
| X<br>A | JP 2015-160855 A (Inoac Corp.), 07 September 2015 (07.09.2015), claims; paragraphs [0016], [0032] to [0049] (Family: none) | 1-5,7<br>6,8 |
| A | JP 2014-026968 A (Cemedine Co., Ltd.), 06 February 2014 (06.02.2014), entire text (Family: none) | 1-8 |

☒ Further documents are listed in the continuation of Box C. ☐ See patent family annex.

* Special categories of cited documents:
"A" document defining the general state of the art which is not considered to be of particular relevance
"E" earlier application or patent but published on or after the international filing date
"L" document which may throw doubts on priority claim(s) or which is cited to establish the publication date of another citation or other special reason (as specified)
"O" document referring to an oral disclosure, use, exhibition or other means
"P" document published prior to the international filing date but later than the priority date claimed
"T" later document published after the international filing date or priority date and not in conflict with the application but cited to understand the principle or theory underlying the invention
"X" document of particular relevance; the claimed invention cannot be considered novel or cannot be considered to involve an inventive step when the document is taken alone
"Y" document of particular relevance; the claimed invention cannot be considered to involve an inventive step when the document is combined with one or more other such documents, such combination being obvious to a person skilled in the art
"&" document member of the same patent family

| Date of the actual completion of the international search | Date of mailing of the international search report |
|---|---|
| 24 October 2016 (24.10.16) | 08 November 2016 (08.11.16) |

| Name and mailing address of the ISA/ | Authorized officer |
|---|---|
| Japan Patent Office<br>3-4-3,Kasumigaseki,Chiyoda-ku,<br>Tokyo 100-8915,Japan | Telephone No. |

Form PCT/ISA/210 (second sheet) (January 2015)

**INTERNATIONAL SEARCH REPORT**

International application No.
PCT/JP2016/073204

C (Continuation). DOCUMENTS CONSIDERED TO BE RELEVANT

| Category* | Citation of document, with indication, where appropriate, of the relevant passages | Relevant to claim No. |
|---|---|---|
| A | JP 2010-102988 A (Toyobo Co., Ltd.), 06 May 2010 (06.05.2010), entire text & US 2010/0101842 A1 full text & CN 101728003 A & TW 201025359 A | 1-8 |
| A | JP 2009-269985 A (Tigers Polymer Corp.), 19 November 2009 (19.11.2009), entire text (Family: none) | 1-8 |
| A | JP 2009-138141 A (Hitachi Cable Ltd.), 25 June 2009 (25.06.2009), entire text (Family: none) | 1-8 |
| A | JP 2006-241365 A (Sumitomo Metal Mining Co., Ltd.), 14 September 2006 (14.09.2006), entire text (Family: none) | 1-8 |
| A | JP 2005-100884 A (Shin-Etsu Polymer Co., Ltd.), 14 April 2005 (14.04.2005), entire text (Family: none) | 1-8 |
| A | JP 2003-045229 A (Toppan Forms Co., Ltd.), 14 February 2003 (14.02.2003), entire text (Family: none) | 1-8 |
| A | JP 2002-197921 A (Toppan Forms Co., Ltd.), 12 July 2002 (12.07.2002), entire text (Family: none) | 1-8 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2001261778 A
- JP 2007516326 PCT
- JP 2005515281 PCT